# FASCICULE DE BREVET EUROPEEN

(11) **EP 3 853 775 B1**
(45) Date de publication et mention de la délivrance du brevet: **26.07.2023**
(21) Numéro de dépôt: 19768845.0
(22) Date de dépôt: 18.09.2019
(51) Int. Cl.: G06K 19/077

(54) **PROCEDE DE FABRICATION D'UN MODULE A CARTE ET LE MODULE OBTENU**
VERFAHREN ZUR HERSTELLUNG EINES KARTENMODULS UND HERGESTELLTES MODUL
METHOD FOR MANUFACTURING A CARD MODULE AND MODULE OBTAINED

(30) Priorité: 18.09.2018 FR 1858423
(43) Date de publication de la demande: 28.07.2021
(73) Titulaire: Smart Packaging Solutions (SPS), 13790 Rousset (FR)
(72) Inventeur: MEAR, Benjamin, 13790 ROUSSET (FR); GERIN, Guillaume, 13790 ROUSSET (FR)
(74) Mandataire: Nicolle, Olivier
(86) Numéro de dépôt international: PCT/EP2019/074999
(87) Numéro de publication internationale: WO 2020/058331

(56) Documents cités:
- DE-C1- 10 108 080
- FR-A1- 2 753 819
- FR-A1- 2 957 175
- US-A1- 2013 140 370

## Description

L'invention concerne un procédé pour fabriquer un module pour un objet portatif, par exemple une carte à puce.

La carte peut être une carte dual (avec une fonction sans contact et avec contact), une carte hybride pouvant être utilisées dans le domaine bancaire ou dans d'autres applications, ou une carte avec une fonction à contact.

Il existe de nombreuses techniques de fabrication de cartes possédant une fonction sans contact et une fonction avec contact. En général, les cartes à puce ou circuit intégré sont constituées d'un micro module incluant une puce et un circuit imprimé flexible avec une ou deux couches en cuivre gravé métallisé.

Ces techniques de fabrication se révèlent souvent coûteuses.

Le document US 2013/140370A1 divulgue une puce RFID montée en « flip-chip » sur un substrat comprenant une antenne de manière à améliorer la robustesse des connexions entre les deux dispositifs.

Le document FR 2957175 A1 divulgue un dispositif électronique à puce comportant au moins un film support souple comprenant au moins une plage de contact, tel que chaque plage soit reliés par interconnexion à travers le film support, à savoir un via de connexion.

Le document FR 2753819 A1 divulgue une carte à circuit intégré à connexion mixte comportant un corps de carte dans lequel est noyé un circuit de liaison à un organe de couplage sans contact pour relier celui-ci à un module comprenant un circuit intégré relié à des plages conductrices à travers des vias traversants.

Le document DE 10108080 C1 divulgue un module sans contact avec un couplage capacitif.

L'un des objectifs de la présente invention est de proposer un procédé de fabrication qui est d'un coût inférieur à celui habituellement utilisé dans l'art antérieur, tout en conservant les fonctionnalités avec contact ou sans contact.

L'objet de l'invention repose sur une nouvelle structure pour le module électronique destiné à être intégré dans l'objet portatif.

L'invention concerne un procédé de fabrication d'un module électronique comportant en combinaison au moins les étapes suivantes :
- Utiliser un substrat comprenant sur au moins une face une ou plusieurs pistes électriquement conductrices, au moins une plage conductrice et au moins un plot de connexion,
- Connecter un circuit intégré à au moins un plot de connexion,
- Disposer d'un ou plusieurs éléments électriquement conducteurs,
- Connecter le ou lesdits éléments électriquement conducteurs à ladite au moins une plage conductrice du substrat en utilisant un adhésif électriquement conducteur, le circuit intégré étant du même côté que le ou les éléments électriquement conducteurs par rapport au substrat; la ou les pistes électriquement conductrices, la au moins une plage conductrice et la au moins un plot de connexion étant du même côté que le ou les éléments électriquement conducteurs par rapport au substrat.

Selon un mode de réalisation, on connecte le ou lesdits éléments électriquement conducteurs à un ou plusieurs plots de connexion avec un adhésif conducteur anisotropique ou un adhésif conducteur isotropique.

Selon un mode de réalisation, la piste conductrice est située dans le prolongement d'une plage conductrice et comprend à au moins une de ses extrémités un plot de connexion.

On utilise, par exemple, un substrat double face comprenant en plus des pistes électriquement conductrices une ou plusieurs spires formant une antenne disposée sur une deuxième face du substrat, une spire ayant une extrémité connectée au circuit intégré.

Il est possible d'utiliser un substrat comprenant en plus des pistes électriquement conductrices reliées aux plots de connexion, une ou plusieurs plages conductrices, lesdites plages conductrices étant connectées au circuit intégré.

La connexion du circuit intégré aux pistes électriquement conductrices du substrat est, par exemple, réalisée en utilisant des fils conducteurs, communément appelé « wire-bonding » par l'homme du métier.

La connexion du circuit intégré aux pistes électriquement conductrices du substrat peut aussi, par exemple, être réalisée en utilisant la technique de puce inversée ou « flip-chip ».

Les pistes électriquement conductrices du substrat peuvent être en aluminium, en cuivre ou encore en matière électriquement conductrice imprimée.

L'invention concerne aussi un module électronique comportant au moins les éléments suivants :
- Un substrat comprenant sur au moins une face une ou plusieurs pistes électriquement conductrices, une piste électriquement conductrice étant située dans le prolongement d'une plage conductrice et comprenant à au moins une de ses extrémités un plot de connexion,
- Un circuit intégré connecté à au moins un plot de connexion,
- Un ou plusieurs éléments électriquement conducteurs,
- Le ou lesdits éléments électriquement conducteurs étant connecté(s) à ladite au moins une plage conductrice du substrat en utilisant un adhésif électriquement conducteur, le circuit intégré étant du même côté que le ou les éléments électriquement conducteurs par rapport au substrat; la ou les pistes électriquement conductrices, la au moins une plage conductrice et la au moins un plot de connexion étant du même côté que le ou les éléments électriquement conducteurs par rapport au substrat.

Le module électronique comprend un substrat double face comportant sur une première face lesdites pistes métalliques et sur une deuxième face une ou plusieurs surfaces conductrices.

La piste conductrice est située dans le prolongement d'une plage conductrice et comprend à au moins une de ses extrémités un plot de connexion.

L'invention concerne aussi le procédé de fabrication d'un objet portatif dans lequel un module électronique selon l'invention est inséré dans une cavité dudit objet portatif utilisant un moyen de communication de type sans contact et/ou avec contact.

Selon un mode de réalisation, l'objet portatif utilisé est un objet à double interface de communication incluant une antenne.

Selon un mode de réalisation, le procédé de fabrication de l'objet portatif comprend les étapes suivantes:
- On utilise un module électronique selon l'invention,
- On enfouit dans l'objet portatif un ou plusieurs supports comprenant une antenne et/ou plusieurs surfaces métalliques adaptées à réaliser une connexion capacitive entre l'antenne et le module électronique,
- On assemble ledit module électronique au support en utilisant une couche adhésive.

Selon un mode de réalisation, on dispose le module électronique dans une cavité d'un objet portatif comprenant un support enfoui sur lequel sont déposés une antenne et un moyen adapté à assurer une connexion par couplage inductif entre l'antenne dudit objet portatif et le module électronique.

On insère par exemple le module électronique dans une carte à double interface de communication et l'on connecte l'antenne de la carte et deux des plots du substrat en utilisant un adhésif conducteur.

D'autres caractéristiques et avantages de la présente invention apparaîtront mieux à la lecture de la description, d'exemples de réalisation donnés à titre illustratif et nullement limitatif, annexée des figures qui représentent :
- Figure 1A, plusieurs vues de face d'un module électronique selon l'invention,
- Figure 1B, une vue en coupe montrant les plots de connexion de la grille et les plages de connexion pour la puce,
- Figure 2, une vue en coupe d'une carte comprenant un module selon la figure 1,
- Figure 3, une vue en coupe d'une version où le montage de la puce est de type flip-chip,
- Figure 4, une vue en coupe d'une variante d'un module électronique double face à connexion de type capacitif, intégré dans une carte avec fonction sans contact,
- Figure 5, une vue en coupe d'une variante d'un module électronique double face à connexion utilisant une technologie de connexion physique, pour connecter l'antenne de la carte assurant une fonction sans contact avec le module, et
- Figure 6, une vue en coupe d'un module double face avec couplage inductif avec une fonction sans contact d'une carte.

La description qui suit est donnée pour la fabrication d'un module électronique comprenant une puce ou circuit intégré comprenant différentes variantes de réalisation.

Différentes variantes de réalisation vont maintenant être décrites, dans lesquelles une piste conductrice pourra se trouver dans le prolongement d'une plage conductrice, mais aussi dans le prolongement d'une spire d'antenne ou encore d'une surface conductrice.

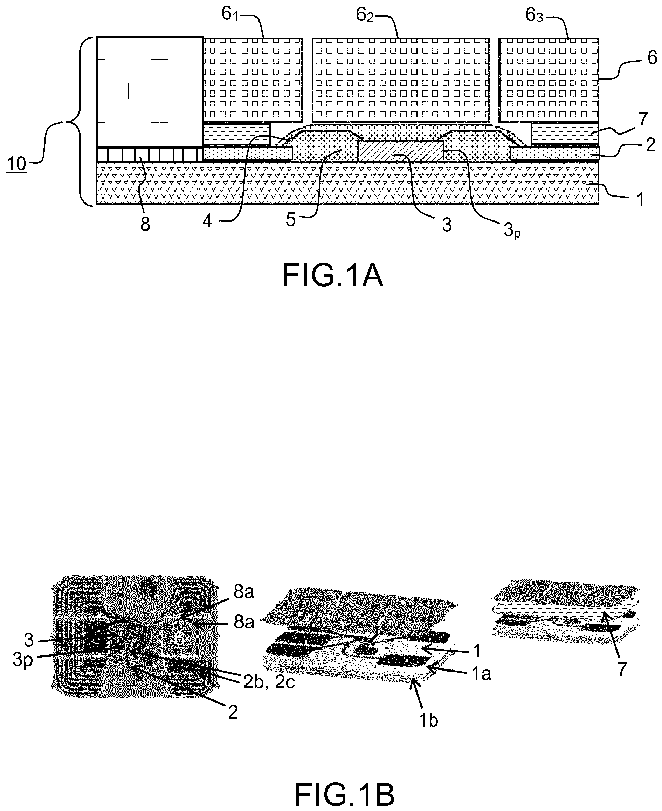

Les figures 1A et 1B illustrent un exemple de module électronique 10 selon l'invention comprenant un substrat 1 sur lequel sur une première face 1a on dépose une ou plusieurs pistes conductrices 2 dans le prolongement d'une plage conductrice 2b et comprenant à une extrémité un plot de connexion 2c disposées elles-mêmes sur la première face 1a. De la même manière, des pistes conductrices 8 sont disposées sur cette même première face 1a afin de réaliser la connexion de la puce 3 et le corps de carte. Un élément électriquement conducteur 6 est connecté aux plages conductrices 2b du substrat à l'aide d'un moyen électriquement conducteur. Le moyen électriquement conducteur est réalisé par un adhésif conducteur 7. La puce 3 est, par exemple, localisée entre l'élément électriquement conducteur 6 et une face du substrat.

Les pistes conductrices sont par exemple une antenne.

L'élément conducteur peut comporter une ou plusieurs plages de contact, par exemple : 6₁, 6₂, 6₃, de type ISO.

Avantageusement, le moyen électriquement conducteur est un adhésif conducteur anisotropique privilégiant la conduction dans une direction choisie.

Selon un mode de réalisation, le substrat du module est un substrat double face comprenant des vias de connexion 10 des deux faces du substrat. Une ou plusieurs spires métalliques constituant une antenne 8 sont déposées sur une deuxième face 1b du substrat opposée à la première face 1a comprenant l'élément conducteur, la ou les spires de l'antenne ayant deux extrémités 8a, chacune étant connectée à un plot 3p de la puce.

Les pistes électriquement conductrices du substrat seront par exemple réalisées en aluminium, en cuivre, ou en matière électriquement conductrice imprimée.

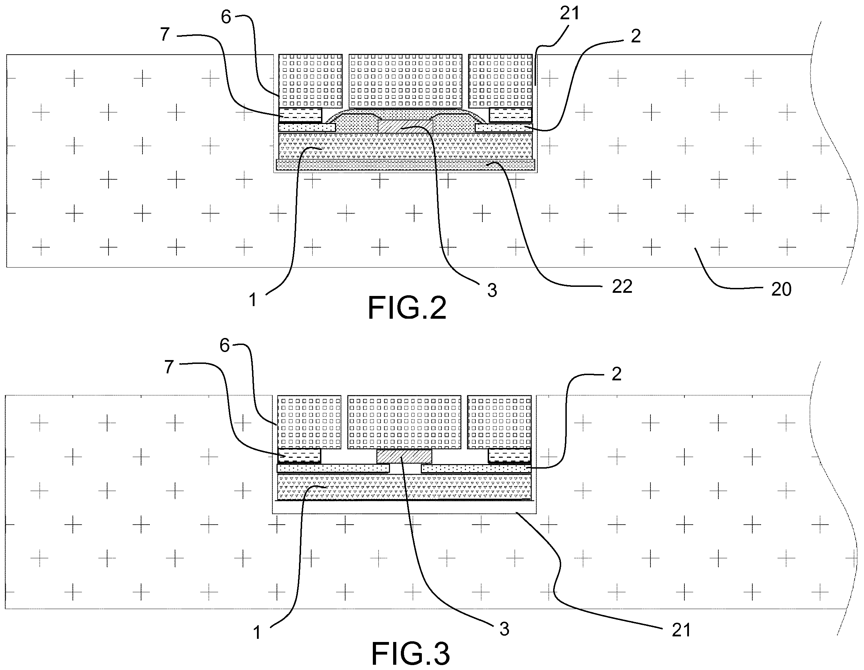

Le module électronique ainsi obtenu est ensuite positionné dans une carte 20, figure 2, et maintenu dans une cavité 21 du corps de carte en utilisant une colle thermofusible 22 ou « hotmelt ». Tout moyen permettant la connexion du module électronique avec les éléments de la carte peut être utilisé. Le hotmelt conducteur ou ACF (Anisotropic Conductive Film) est composé, par exemple, de petits éléments conducteurs présents dans l'adhésif et réalise une connexion en Z (direction perpendiculaire au plan du support) lorsqu'il est pressé ou laminé. C'est pourquoi il est possible de le déposer entre la grille et les plages de connexion, sans risque que les contacts ISO ou les pistes soient court-circuitées.

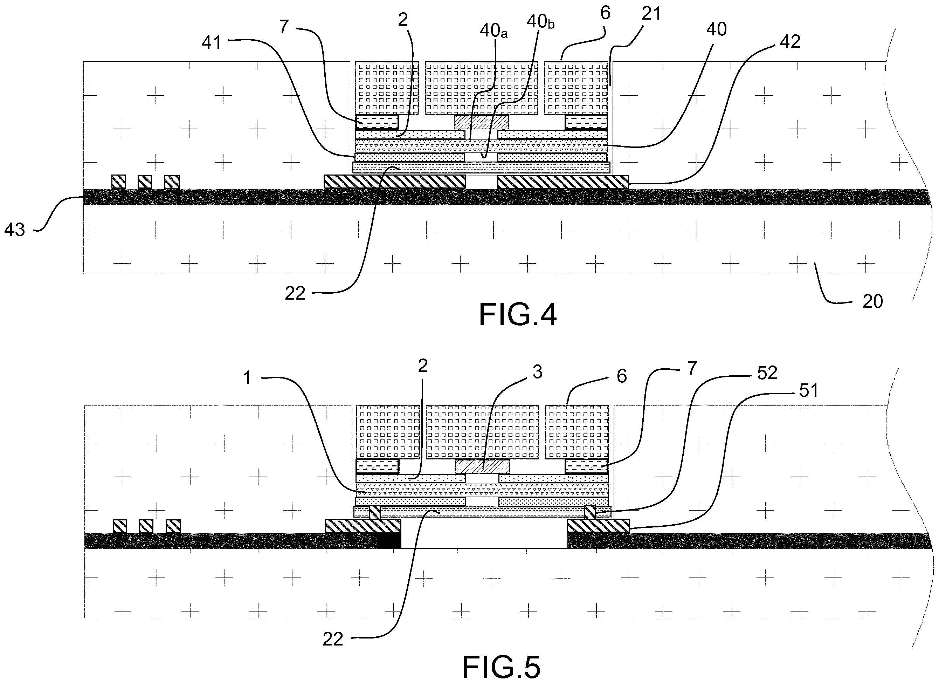

La figure 3 illustre une variante de réalisation dans laquelle, la connexion de la puce 3 avec les pistes conductrices du substrat est de type flip-chip ou puce retournée. La puce 3 est retournée sur des plots de colle conductrice (non représenté pour des raisons de simplification) ou « bump » afin de réaliser la connexion avec les plots de connexion de la puce en dessous. La figure 4 illustre le positionnement d'un module électronique double face selon l'invention inséré dans une cavité 21 d'une carte 20. La fabrication d'un tel module électronique utilise un substrat double face 40. Sur une première face 40a du substrat on dépose une ou plusieurs pistes conductrices 2 et sur une deuxième face 40b opposée à la première face une ou plusieurs surfaces conductrices 41. Cette figure illustre une connexion de la puce avec une technique de flip-chip. Il est aussi possible de réaliser la connexion de la puce en utilisant une technique de câblage, ou « wire-bond ».

Le « Holmelt » sert d'isolant diélectrique entre les surfaces conductrices 41 situées sur la face du module en contact avec le hotmelt et des surfaces métalliques 42 du substrat 43 enfoui dans le corps de carte et ayant pour fonction de réaliser une connexion capacitive. Le hotmelt sert d'isolant diélectrique pour la formation de deux capacités. Le substrat de la carte est le support de l'antenne formée par les surfaces métalliques 42 et insérée dans le corps de carte.

La figure 5 schématise une variante de réalisation dans laquelle l'antenne 51 de la carte est connectée physiquement par deux zones 52 à la partie métallique du module selon des technologies connues de l'homme du métier, telle que la soudure, l'adhésif conducteur, la colle conductrice, des polymères conducteurs ou toute autre méthode.

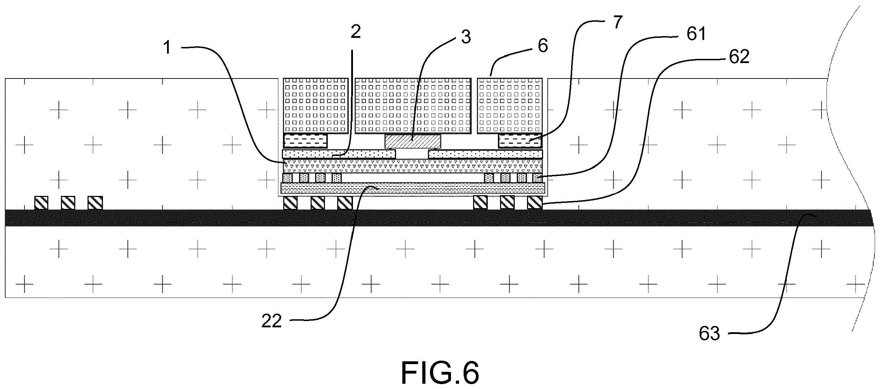

La figure 6 illustre une variante de réalisation, du module composé d'un substrat double face. Une face métallique 61 du substrat forme une antenne qui va permettre un couplage inductif avec l'antenne 62 située sur le substrat 63 du corps de carte.

La description ci-dessus peut être mise en oeuvre pour un substrat simple face ou un substrat double face.

Le module fabriqué par le procédé selon l'invention peut être inséré dans une carte ayant une fonction sans contact, l'élément métallique connecté aux plots du substrat contenant la puce est alors inséré dans le corps de la carte sans contact.

Une autre application consiste à utiliser le micromodule dans une carte à double interface de communication incluant une antenne.

Selon une autre application, le module est inséré dans une carte à double interface de communication incluant une antenne et dans laquelle l'interface de communication entre l'antenne et deux des plots du substrat est réalisée par couplage capacitif.

Le module selon l'invention peut aussi être inséré dans une carte pour une application dite de carte à double interface de communication incluant une antenne et une connexion entre l'antenne et deux des plots du substrat réalisé à l'aide d'un adhésif conducteur.

Les pistes métalliques présentes sur le substrat et reliées aux plots de connexion et à la puce sont par exemple localisées sur chacune des deux faces du substrat.

Le procédé selon l'invention permet de produire un module électronique destiné à une utilisation dans un objet portatif avec une fonction sans contact et/ou avec contact avec un faible coût comparé aux technologies habituellement utilisées.

## Revendications

1. - Procédé de fabrication d'un module électronique comportant en combinaison au moins les étapes suivantes
• Utiliser un substrat (1) comprenant sur au moins une face (1a) une ou plusieurs pistes électriquement conductrices (2), au moins une plage conductrice (2b) et au moins un plot de connexion (2c),
• Connecter un circuit intégré (3) à au moins un plot de connexion (2c)
• Disposer d'un ou plusieurs éléments électriquement conducteurs (6), **caractérisé en ce que** le procédé comprend l'étape de
• Connecter le ou lesdits éléments électriquement conducteurs (6) à ladite au moins une plage conductrice (2b) du substrat (1) en utilisant un adhésif électriquement conducteur (7), le circuit intégré (3) étant du même côté que le ou les éléments électriquement conducteurs (6) par rapport au substrat (1) ; la ou les pistes électriquement conductrices (2), la au moins une plage conductrice (2b) et la au moins un plot de connexion (2c) étant du même côté que le ou les éléments électriquement conducteurs (6) par rapport au substrat (1).

2. - Procédé de fabrication selon la revendication 1 **caractérisé en ce que** l'adhésif électriquement conducteur (7) est un adhésif conducteur anisotropique.

3. - Procédé de fabrication selon la revendication 1 **caractérisé en ce que** l'adhésif électriquement conducteur (7) est un adhésif conducteur isotropique.

4. - Procédé selon la revendication 1 **caractérisé en ce qu'**une piste conductrice (2) est située dans le prolongement d'une plage conductrice (2b) et comprend à au moins une de ses extrémités un plot de connexion.

5. - Procédé selon l'une des revendications précédentes **caractérisé en ce que** l'on utilise un substrat (1) double face comprenant en plus des pistes électriquement conductrices (2), une ou plusieurs spires (8) formant une antenne disposée sur une deuxième face (1b) du substrat, une spire ayant une extrémité (8a) connectée au circuit intégré (3).

6. - Procédé selon l'une des revendications 1 à 5 **caractérisé en ce que** l'on utilise un substrat (1) comprenant en plus des pistes électriquement conductrices (2) reliées aux plots de connexion (2c), une ou plusieurs surfaces conductrices (41), lesdites surfaces conductrices (41) étant connectées au circuit intégré (3).

7. - Procédé selon l'une des revendications précédentes **caractérisé en ce que** l'on connecte le circuit intégré (3) aux pistes électriquement conductrices (2) du substrat (1) en utilisant des fils conducteurs (4) ou « wire bond ».

8. - Procédé selon l'une des revendications 1 à 6 **caractérisé en ce que** la connexion du circuit intégré aux pistes électriquement conductrices (2) du substrat (1) est réalisée en utilisant la technique de puce inversée ou flip-chip.

9. - Procédé selon l'une des revendications précédentes **caractérisé en ce que** les pistes électriquement conductrices (2) du substrat (1) sont en aluminium.

10. - Procédé selon l'une des revendications 1 à 8 **caractérisé en ce que** les pistes électriquement conductrices (2) du substrat (1) sont en cuivre.

11. - Procédé selon l'une des revendications 1 à 8 **caractérisé en ce que** les pistes électriquement conductrices (2) du substrat (1) sont en matière électriquement conductrice imprimée.

12. - Module électronique (10) comportant au moins les éléments suivants :
• Un substrat (1) comprenant sur au moins une face (1a) une ou plusieurs pistes électriquement conductrices (2), au moins une plage conductrice (2b) et au moins un plot de connexion (2c),
• Un circuit intégré (3) connecté à au moins un plot de connexion (2c),
• Un ou plusieurs éléments électriquement conducteurs (6), **caractérisé en ce que**
• Le ou lesdits éléments électriquement conducteurs (6) est/sont connecté(s) à ladite au moins une plage conductrice (2b) du substrat (1) en utilisant un adhésif (7) électriquement conducteur, le circuit intégré (3) étant du même côté que le ou les éléments électriquement conducteurs (6) par rapport au substrat (1) ; la ou les pistes électriquement conductrices (2), la au moins une plage conductrice (2b) et la au moins un plot de connexion (2c) étant du même côté que le ou les éléments électriquement conducteurs (6) par rapport au substrat (1).

13. - Module selon la revendication 12 **caractérisé en ce qu'**on utilise un module électronique (10) comprenant un substrat double face (40) comportant sur une première face (40a) lesdites pistes électriquement conductrices (2) et sur une deuxième face (40b) une ou plusieurs surfaces conductrices (41).

14. - Module électronique selon la revendication 13 **caractérisé en ce qu'**une piste conductrice (2) est située dans le prolongement d'une plage conductrice (2b) et comprend à au moins une de ses extrémités un plot de connexion.

15. - Procédé de fabrication d'un objet portatif **caractérisé en ce que** l'on insère un module électronique (10) selon la revendication 13 dans une cavité (21) dudit objet portatif utilisant un moyen de communication de type sans contact et/ou avec contact.

16. - Procédé selon la revendication 15 **caractérisé en ce que** l'on utilise un objet portatif à double interface de communication incluant une antenne.

17. - Procédé selon la revendication 15 **caractérisé en ce que** l'on enfouit dans l'objet portatif un ou plusieurs supports (43) comprenant une antenne et/ou plusieurs surfaces métalliques (42) adaptées à réaliser une connexion capacitive entre l'antenne et le module électronique (10).

18. - Procédé selon la revendication 15 **caractérisé en ce que** l'on dispose ledit module électronique (10) dans une cavité d'un objet portatif comprenant un support enfoui sur lequel sont déposés une antenne et un moyen adapté à assurer une connexion par couplage inductif entre l'antenne dudit objet portatif et le module électronique (10).

19. - Procédé selon la revendication 15 **caractérisé en ce que** l'on insère le module électronique (10) dans une carte à double interface de communication et l'on connecte l'antenne de la carte et deux des plots du substrat en utilisant un moyen électriquement conducteur.

20. - Procédé selon la revendication 19 **caractérisé en ce que** le moyen électriquement conducteur est un adhésif électriquement conducteur.

21. - Procédé selon la revendication 19 **caractérisé en ce que** le moyen électriquement conducteur est un adhésif anisotropique.

## Patentansprüche

1. - Verfahren zur Herstellung eines elektronischen Moduls, das in Kombination mindestens die folgenden Schritte umfasst
• die Verwendung eines Substrats (1), das auf mindestens einer Seite (1a) eine oder mehrere elektrisch leitfähige Bahnen (2), mindestens einen leitfähigen Bereich (2b) und mindestens ein Anschlusspad (2c) umfasst,
• das Verbinden eines integrierten Schaltkreises (3) mit mindestens einem Anschlusspad (2c),
• das Verfügen über ein oder mehrere elektrisch leitfähige Elemente (6), **dadurch gekennzeichnet, dass** das Verfahren den folgenden Schritt umfasst,
• das Verbinden des mindestens einen elektrisch leitfähigen Elements (6) mit dem mindestens einen leitfähigen Bereich (2b) des Substrats (1) unter Verwendung eines elektrisch leitfähigen Klebstoffs (7), wobei sich der integrierte Schaltkreis (3) in Bezug auf das Substrat (1) auf derselben Seite wie das oder die elektrisch leitfähigen Elemente (6) befindet; wobei sich die elektrisch leitfähige(n) Bahn(en) (2), der mindestens eine leitfähige Bereich (2b) und das mindestens eine Anschlusspad (2c) in Bezug auf das Substrat (1) auf derselben Seite wie das oder die elektrisch leitfähigen Elemente (6) befinden.

2. - Herstellungsverfahren nach Anspruch 1, **dadurch gekennzeichnet, dass** der elektrisch leitfähige Klebstoff (7) ein anisotrop leitfähiger Klebstoff ist.

3. - Herstellungsverfahren nach Anspruch 1, **dadurch gekennzeichnet, dass** der elektrisch leitfähige Klebstoff (7) ein isotrop leitfähiger Klebstoff ist.

4. - Verfahren nach Anspruch 1, **dadurch gekennzeichnet, dass** sich eine Leiterbahn (2) in der Verlängerung eines leitfähigen Bereichs (2b) befindet und an mindestens einem ihrer Enden ein Anschlusspad umfasst.

5. - Verfahren nach einem der vorhergehenden Ansprüche, **dadurch gekennzeichnet, dass** ein doppelseitiges Substrat (1) verwendet wird, das zusätzlich zu den elektrisch leitfähigen Bahnen (2) eine oder mehrere Windungen (8) umfasst, die eine auf einer zweiten Seite (1b) des Substrats angeordnete Antenne bilden, wobei eine Windung ein Ende (8a) hat, das mit dem integrierten Schaltkreis (3) verbunden ist.

6. - Verfahren nach einem der Ansprüche 1 bis 5, **dadurch gekennzeichnet, dass** ein Substrat (1) verwendet wird, das zusätzlich zu den elektrisch leitfähigen Bahnen (2), die mit den Anschlusspads (2c) verbunden sind, eine oder mehrere leitfähige Oberflächen (41) umfasst, wobei die leitfähigen Oberflächen (41) mit dem integrierten Schaltkreis (3) verbunden sind.

7. - Verfahren nach einem der vorhergehenden Ansprüche, **dadurch gekennzeichnet, dass** der integrierte Schaltkreis (3) mit den elektrisch leitfähigen Bahnen (2) des Substrats (1) unter Verwendung von Leitungsdrähten (4) oder "wire bonds" verbunden wird.

8. - Verfahren nach einem der Ansprüche 1 bis 6, **dadurch gekennzeichnet, dass** die Verbindung des integrierten Schaltkreises mit den elektrisch leitfähigen Bahnen (2) des Substrats (1) unter Anwendung der Wende-Montage oder Flip-Chip-Technik hergestellt wird.

9. - Verfahren nach einem der vorhergehenden Ansprüche, **dadurch gekennzeichnet, dass** die elektrisch leitfähigen Bahnen (2) des Substrats (1) aus Aluminium bestehen.

10. - Verfahren nach einem der Ansprüche 1 bis 8, **dadurch gekennzeichnet, dass** die elektrisch leitfähigen Bahnen (2) des Substrats (1) aus Kupfer bestehen.

11. - Verfahren nach einem der Ansprüche 1 bis 8, **dadurch gekennzeichnet, dass** die elektrisch leitfähigen Bahnen (2) des Substrats (1) aus gedrucktem, elektrisch leitendem Material bestehen.

12. - Elektronisches Modul (10), das mindestens folgende Elemente umfasst:
• ein Substrat (1), das auf mindestens einer Seite (1a) eine oder mehrere elektrisch leitfähige Bahnen (2), mindestens einen leitfähigen Bereich (2b) und mindestens ein Anschlusspad (2c) umfasst,
• einen integrierten Schaltkreis (3), der mit mindestens einem Anschlusspad (2c) verbunden ist,
• ein oder mehrere elektrisch leitfähige Elemente (6), **dadurch gekennzeichnet, dass**,
• das oder die elektrisch leitfähigen Elemente (6) mit dem mindestens einen leitfähigen Bereich (2b) des Substrats (1) unter Verwendung eines elektrisch leitfähigen Klebstoffs (7) verbunden ist/sind, wobei sich der integrierte Schaltkreis (3) in Bezug auf das Substrat (1) auf derselben Seite wie der oder die elektrisch leitfähigen Elemente (6) befindet; wobei sich die elektrisch leitfähige(n) Bahn(en) (2), der mindestens eine leitfähige Bereich (2b) und das mindestens eine Anschlusspad (2c) in Bezug auf das Substrat (1) auf derselben Seite wie das mindestens eine elektrisch leitfähige Element (6) befinden.

13. - Modul nach Anspruch 12, **dadurch gekennzeichnet, dass** ein elektronisches Modul (10) mit einem doppelseitigen Substrat (40) verwendet wird, das auf einer ersten Seite (40a) die elektrisch leitfähigen Bahnen (2) und auf einer zweiten Seite (40b) eine oder mehrere leitfähige Oberflächen (41) umfasst.

14. - Elektronisches Modul nach Anspruch 13, **dadurch gekennzeichnet, dass** sich eine Leiterbahn (2) in der Verlängerung eines leitfähigen Bereichs (2b) befindet und es an mindestens einem ihrer Enden ein Anschlusspad umfasst.

15. - Verfahren zur Herstellung eines tragbaren Gegenstands, **dadurch gekennzeichnet, dass** ein elektronisches Modul (10) nach Anspruch 13 unter Verwendung eines kontaktlosen und/oder kontaktbasierten Kommunikationsmittels in einen Hohlraum (21) des tragbaren Gegenstands eingesetzt wird.

16. - Verfahren nach Anspruch 15, **dadurch gekennzeichnet, dass** ein tragbarer Gegenstand mit doppelter Kommunikationsschnittstelle verwendet wird, der eine Antenne enthält.

17. - Verfahren nach Anspruch 15, **dadurch gekennzeichnet, dass** in dem tragbaren Gegenstand ein oder mehrere Träger (43) eingebettet werden, die eine Antenne und/oder mehrere Metalloberflächen (42) zur Herstellung einer kapazitiven Kopplung zwischen der Antenne und dem elektronischen Modul (10) umfassen.

18. - Verfahren nach Anspruch 15, **dadurch gekennzeichnet, dass** das elektronische Modul (10) in einem Hohlraum eines tragbaren Gegenstandes mit eingebettetem Träger angeordnet ist, auf dem eine Antenne angebracht ist und ein Mittel zur Herstellung einer Verbindung zwischen der Antenne des tragbaren Gegenstandes und dem elektronischen Modul (10) durch induktive Kopplung.

19. - Verfahren nach Anspruch 15, **dadurch gekennzeichnet, dass** das elektronische Modul (10) in eine Karte mit doppelter Kommunikationsschnittstelle einsetzt wird und die Antenne der Karte und zwei der Pads des Substrats unter Verwendung eines elektrisch leitfähigen Mittels verbunden werden.

20. - Verfahren nach Anspruch 19 **dadurch gekennzeichnet, dass** das elektrisch leitfähige Mittel ein elektrisch leitfähiger Klebstoff ist.

21. - Verfahren nach Anspruch 19 **dadurch gekennzeichnet, dass** das elektrisch leitfähige Mittel ein anisotroper Klebstoff ist.

## Claims

1. - A method of manufacturing an electronic module comprising in combination at least the following steps
• Using a substrate (1) comprising on at least one side (1a) one or more electrically conductive tracks (2), at least one conductive pad (2b) and at least one connection stud (2c),
• Connecting an integrated circuit (3) to at least one connection stud (2c),
• Arranging one or more electrically conductive elements (6), **characterised in that** the method comprises the step of,
• Connecting said electrically conductive element(s) (6) to said at least one conductive pad (2b) of the substrate (1) using an electrically conductive adhesive (7), wherein the integrated circuit (3) is on the same side as the electrically conductive element (s) (6) with respect to the substrate (1); the electrically conductive track(s) (2), the at least one conductive pad (2b) and the at least one connection stud (2c) are on the same side as the electrically conductive element(s) (6) with respect to the substrate (1).

2. - The manufacturing method according to claim 1, **characterised in that** the electrically conductive adhesive (7) is an anisotropic conductive adhesive.

3. - The manufacturing method according to claim 1, **characterised in that** the electrically conductive adhesive (7) is an anisotropic conductive adhesive.

4. - The method according to claim 1, **characterised in that** a conductive track (2) is located in the extension of a conductive pad (2b) and comprises a connection stud at at least one of its ends.

5. - The method according to any of the preceding claims, **characterised in that** a double-sided substrate (1) is used comprising, in addition to the electrically conductive tracks (2), one or more turns (8) forming an antenna arranged on a second side (1b) of the substrate, wherein a turn has an end (8a) connected to the integrated circuit (3) .

6. - The method according to any of claims 1 to 5, **characterised in that** use is made of a substrate (1) comprising, in addition to the electrically conductive tracks (2) connected to the connection studs (2c), one or more conductive surfaces (41), wherein said conductive surfaces (41) are connected to the integrated circuit (3).

7. - The method according to any of the preceding claims, **characterised in that** the integrated circuit (3) is connected to the electrically conductive tracks (2) of the substrate (1) using conductive wires (4) or "wire bond".

8. - The method according to any of claims 1 to 6, **characterised in that** the integrated circuit is connected to the electrically conductive tracks (2) of the substrate (1) using the flip-chip technique.

9. - The method according to any of the preceding claims, **characterised in that** the electrically conductive tracks (2) of the substrate (1) are made of aluminium.

10. - The method according to any of claims 1 to 8, **characterised in that** the electrically conductive tracks (2) of the substrate (1) are made of copper.

11. - The method according to any claims 1 to 8, **characterised in that** the electrically conductive tracks (2) of the substrate (1) are made of printed electrically conductive material.

12. - An electronic module (10) comprising at least the following elements:
• A substrate (1) comprising on at least one side (1a) one or more electrically conductive tracks (2), at least one conductive pad (2b) and at least one connection stud (2c),
• An integrated circuit (3) connected to at least one connection stud (2c),
• One or more electrically conductive elements (6), **characterised in that**,
• The electrically conductive element(s) (6) is/are connected to said at least one conductive pad (2b) of the substrate (1) using an electrically conductive adhesive (7), wherein the integrated circuit (3) is on the same side as the electrically conductive element (s) (6) with respect to the substrate (1); the electrically conductive track(s) (2), the at least one conductive pad (2b) and the at least one connection stud (2c) are on the same side as the electrically conductive element(s) (6) with respect to the substrate (1).

13. - The module according to claim 12, **characterised in that** an electronic module (10) is used comprising a double-sided substrate (40) having on a first side (40a) said electrically conductive tracks (2) and on a second side (40b) one or more conductive surfaces (41).

14. - The electronic module according to claim 13, **characterised in that** a conductive track (2) is located in the extension of a conductive pad (2b) and comprises a connection stud at at least one of its ends.

15. - A method of manufacturing a portable object, **characterised in that** an electronic module (10) according to claim 13 is inserted into a cavity (21) of said portable object using a contactless and/or contact type communication means.

16. - The method according to claim 15, **characterised in that** a portable object with a dual communication interface including an antenna is used.

17. - The method according to claim 15, **characterised in that** one or more supports (43) comprising an antenna and/or several metal surfaces (42) suitable for producing a capacitive connection between the antenna and the electronic module (10) are buried in the portable object.

18. - The method according to claim 15, **characterised in that** the said electronic module (10) is placed in a cavity of a portable object comprising a buried support on which an antenna and a means suitable for ensuring a connection by inductive coupling between the antenna of the said portable object and the electronic module (10) are arranged.

19. - The method according to claim 15, **characterised in that** the electronic module (10) is inserted into a dual communication interface card and the antenna of the card and two of the studs of the substrate are connected using an electrically conductive means.

20. - The method according to claim 19 **characterised in that** the electrically conductive means is an electrically conductive adhesive.

21. - The method according to claim 19 **characterised in that** the electrically conductive means is an anisotropic adhesive.
